# EUROPÄISCHE PATENTSCHRIFT

(11) **EP 2 245 668 B1**
(45) Veröffentlichungstag und Bekanntmachung des Hinweises auf die Patenterteilung: **15.07.2020**
(21) Anmeldenummer: 09705404.3
(22) Anmeldetag: 26.01.2009
(51) Int. Cl.: H01L 25/075, H01L 27/32, H01L 33/44, H01L 33/50, H04N 9/31, F21K 9/00

(54) **OPTOELEKTRONISCHES MODUL UND PROJEKTIONSVORRICHTUNG MIT DEM OPTOELEKTRONISCHEN MODUL**
OPTOELECTRONIC MODULE AND PROJECTION DEVICE COMPRISING THE OPTOELECTRONIC MODULE
MODULE OPTOÉLECTRONIQUE ET DISPOSITIF DE PROJECTION POURVU DUDIT MODULE OPTOÉLECTRONIQUE

(30) Priorität: 31.01.2008 DE 102008006974; 03.04.2008 DE 102008017071
(43) Veröffentlichungstag der Anmeldung: 03.11.2010
(73) Patentinhaber: OSRAM Opto Semiconductors GmbH, 93055 Regensburg (DE)
(72) Erfinder: PETERSEN, Kirstin, 93059 Regensburg (DE); GRÖTSCH, Stefan, 93077 Lengfeld - Bad Abbach (DE); MILLER, Stephan, 93080 Pentling (DE); SPATH, Günter, 93047 Regensburg (DE); LINDER, Norbert, 93138 Lappersdorf (DE); EISERT, Dominik, 93049 Regensburg (DE); PETER, Matthias, 93087 Alteglofsheim (DE)
(74) Vertreter: Epping - Hermann - Fischer
(86) Internationale Anmeldenummer: PCT/DE2009/000103
(87) Internationale Veröffentlichungsnummer: WO 2009/094994

(56) Entgegenhaltungen:
- EP-A- 1 492 387
- EP-A- 1 768 464
- WO-A-03/093394
- WO-A-2005/051044
- GB-A- 2 404 276
- GB-A- 2 432 249
- JP-A- H11 145 519
- US-A- 5 813 752
- US-A- 5 813 753
- US-A1- 2004 242 115
- US-A1- 2005 259 049

## Beschreibung

Für Projektionsvorrichtungen wird eine Lichtquelle mit einer hohen Lichtleistung benötigt. Herkömmliche Lichtquellen für Projektionsvorrichtungen werden bei hohen Betriebsströmen betrieben und entwickeln eine beträchtliche Abwärme. Durch den Einsatz von Leuchtdiodenchips als Lichtquelle könnten diese nachteiligen Effekte vermieden werden. Bisher ist allerdings die Lichtleistung von Leuchtdiodenchips für eine Vielzahl von Projektionsanwendungen zu gering.

In den Druckschriften WO 2007/036214 A1 und US 2006/0057753 A1 werden optoelektronische Bauelemente angegeben.

Die Druckschriften WO 2005/051044 A1, US 2004/0242115 A1 und WO 03/093394 A1 beschreiben anorganische und organische elektrolumineszente Bauteile.

JP H11 145519 A offenbart ein optoelektronisches Modul mit mehreren Leuchtdiodenchips mit
Filtern und einer Auskopplung-Struktur.

Es ist eine zu lösende Aufgabe, ein optoelektronisches Bauelement mit einer hohen Lichtleistung anzugeben.

Die vorliegende Erfindung wird im Anspruch 1 definiert. Weitere Aspekte der Erfindung werden in den abhängigen Ansprüchen definiert.

Die Erfinder haben festgestellt, dass die strahlenden Effizienzen von Leuchtdiodenchips bei zunehmender Wellenlänge der erzeugten Strahlung stark abnehmen. Beispielsweise ist die strahlende Effizienz eines Leuchtdiodenchips, der UV-Strahlung erzeugt, wesentlich höher als die eines Leuchtdiodenchips, der Strahlung im grünen Wellenlängenbereich erzeugt. Im Folgenden werden diese Leuchtdiodenchips verkürzt als UV-LEDs beziehungsweise als grüne LEDs bezeichnet.

Zum einen ist schon bei niedrigen Betriebsströmen I, zum Beispiel bei I = 20 mA, die abgestrahlte Leistung einer UV-LED höher, als die einer grünen LED. Zum anderen ist bei einer Erhöhung des Betriebsstroms bei einer grünen LED schneller eine Sättigung in der Leistung erreicht als bei einer UV-LED. Dabei ist der Linearitätsfaktor L_{80/20} ein Maß für die Hochstromeffizienz einer Leuchtdiode. L_{80/20} ergibt sich aus dem Quotienten der abgestrahlten Lichtleistungen P bei Betriebsströmen von I = 80 mA und von I = 20 mA. Im Idealfall entspricht dieser Faktor dem Verhältnis der beiden Betriebsströme und liegt bei einem Wert von 4. Während dieser Idealwert bei UV-LEDs nahezu erreicht wird, wird er bei grünen LEDs stark unterschritten.

Es wird ein optoelektronisches Bauelement mit einer UV-LED und einem Wellenlängenkonverter angegeben. Die erzeugte UV-Strahlung wird durch eine Vorderseite der LED abgestrahlt und trifft auf den Wellenlängenkonverter. Dieser wandelt die UV-Strahlung zumindest teilweise in sichtbares Licht um.

Diese Anordnung ermöglicht es, monochromatische Strahlung im sichtbaren Bereich mit hoher Effizienz abzustrahlen. Dabei wird Strahlung als monochromatisch bezeichnet, wenn ihre Wellenlänge in einem eng begrenzten Bereich liegt. Die spektrale Halbwertsbreite Δλ der abgestrahlten Strahlung liegt vorzugsweise im Bereich von 10 nm bis 100 nm.

Ein Leuchtdiodenchip, der ultraviolette Strahlung, das heißt Strahlung mit einer Wellenlänge λ s 420 nm, emittiert, basiert beispielsweise auf Indiumgalliumnitrid (InGaN). Dieser Leuchtdiodenchip kann als Dünnfilmleuchtdiodenchip ausgeführt sein.

Vorzugsweise wandelt der Wellenlängenkonverter die UV-Strahlung in grünes Licht mit einer Hauptwellenlänge λ_{Peak} im Bereich von 490 nm bis 545 nm um. Dabei ist die Hauptwellenlänge die Wellenlänge, bei der das Intensitätsmaximum des abgestrahlten Lichtes liegt.

In anderen Ausführungsformen des Wellenlängenkonverters kann auch blaues Licht im Wellenlängenbereich von 420 nm bis 490 nm, oder rotes oder gelbes Licht im Wellenlängenbereich von 575 nm bis 750 nm erzeugt werden.

Der Wellenlängenkonverter enthält vorzugsweise ein Matrixmaterial, in dem sich Partikel eines Wellenlängenkonversionsstoffes befinden. Als Matrixmaterial eignen sich transparente Materialien wie Glas, Quarz, Saphir, Siliziumcarbid, transparente Keramiken, wie zum Beispiel Al₂O₃, Diamant, Silikon, Acrylate, Polyimid, Polycarbonat, Epoxidharze oder auch Mischungen dieser Materialien. Vorzugsweise weist das Matrixmaterial eine hohe thermische Leitfähigkeit auf und kann dadurch die entstehende Abwärme gut abführen. Materialien mit einer sehr hohen thermischen Leitfähigkeit sind beispielsweise Siliziumcarbid oder Diamant.

Partikel eines Wellenlängenkonversionsstoffes sind vorzugsweise weitestgehend gleichmäßig im Matrixmaterial verteilt.

Als Wellenlängenkonversionsstoffe eignen sich Materialien, die mit Metallen aus der Gruppe der seltenen Erden dotiert sind, wie beispielsweise Granate, Erdalkalisulfide, Thiogalate, Aluminate, Orthosilikate, Chlorosilikate, Erdalkalisiliziumnitride, Oxynitride, Aluminiumoxynitride und Siliziumoxynitride. Beispielsweise wird YAG:Ce, der mit Cerium dotierte Granatleuchtstoff YAG, eingesetzt.

In einer Ausführungsform wird das Matrixmaterial gleichzeitig vom Konvertermaterial gebildet, zum Beispiel kann eine YAG-Keramik verwendet werden. Das heißt, der Wellenlängenkonverter ist zum Beispiel als keramisches Konverterplättchen ausgeführt. In diesem Fall ist der keramische Wellenlängenkonversionsstoff zu einer keramischen Schicht gesintert, in der die Streuung der durchtretenden Strahlung durch die Dichte des keramischen Materials und die Porengröße von Lufteinschlüssen im keramischen Material eingestellt werden kann.

Zudem weist die keramische Schicht eine höhere Wärmeleitfähigkeit als ein Wellenlängenkonverter auf, bei dem der Wellenlängenkonversionsstoff in ein Matrixmaterial wie Silikon eingebracht ist. Auf diese Weise kann Wärme besonders effizient vom Wellenlängenkonverter abgeführt werden.

Die keramische Schicht kann freitragend sein. Die keramische Schicht bildet dann zugleich den Wellenlängenkonverter sowie einen Träger für den Wellenlängenkonverter. Es ist aber auch möglich, dass die keramische Schicht mittels Verfahren wie heiß-isostatisches Pressen oder gepulster Laserabscheidung auf einem transparenten, wärmeleitfähigen Träger wie Saphir oder Siliziumcarbid befestigt oder abgeschieden wird.

In einer bevorzugten Ausführungsform des optoelektronischen Bauelements ist im Strahlengang mindestens ein Filter angeordnet, der für eine der beiden Strahlungsarten ein hohes Transmissionsvermögen und für die andere Strahlungsart ein hohes Reflexionsvermögen aufweist.

Der Ausdruck "hohes Transmissionsvermögen" eines optischen Elements - wie zum Beispiel eines Filters - kann hier und im Folgenden heißen, dass wenigstens 50 % der auf das Element auftreffenden Strahlung durch das Element treten. Vorzugsweise treten wenigstens 75 % der auf das Element auftreffenden Strahlung durch das Element, besonders bevorzugt wenigstens 90 %.

Der Ausdruck "hohes Reflexionsvermögen" eines optischen Elements - wie zum Beispiel eines Filters - kann hier und im Folgenden heißen, dass wenigstens 50 % der auf das Element auftreffenden Strahlung durch das Element reflektiert werden. Vorzugsweise werden wenigstens 75 % der auf das Element auftreffenden Strahlung durch das Element reflektiert, besonders bevorzugt wenigstens 90 %.

Ist dieser Filter selektiv für die UV-Strahlung durchlässig und reflektiert die Strahlung im sichtbaren Wellenlängenbereich, wird er als UV-Filter bezeichnet. Ist er selektiv für das Licht im sichtbaren Bereich durchlässig und reflektiert die UV-Strahlung, wird er mit dem Oberbegriff Sichtbar-Filter bezeichnet. Ist er zur Transmission von Strahlung in einem enger begrenzten Wellenlängenbereich vorgesehen, wird er je nach Wellenlängenbereich mit den Begriffen Grün-Filter, Blau-Filter, Gelb-Filter oder Rot-Filter genauer spezifiziert.

In einer bevorzugten Ausführungsform befindet sich zwischen der UV-LED und dem Wellenlängenkonverter ein UV-Filter, der für die UV-Strahlung ein hohes Transmissionsvermögen und für die Strahlung im sichtbaren Wellenlängenbereich ein hohes Reflexionsvermögen aufweist.

Trifft konvertiertes Licht vom Wellenlängenkonverter aus auf diesen UV-Filter, so wird es zurück in Richtung des Wellenlängenkonverters und insbesondere in Richtung einer Auskoppelstruktur des optoelektronischen Bauelements reflektiert. Dadurch ergibt sich eine erhöhte Auskoppeleffizienz des Bauelements. Ohne einen UV-Filter könnte das sichtbare Licht in der UV-LED, einem Träger oder einem Gehäuse absorbiert werden.

In einer weiteren Ausführungsform befindet sich zwischen dem Wellenlängenkonverter und einer Auskoppelstruktur der UV-LED ein Sichtbar-Filter, der für die Strahlung im sichtbaren Wellenlängenbereich ein hohes Transmissionsvermögen und für die UV-Strahlung ein hohes Reflexionsvermögen aufweist.

Zum einen kann mittels dieses Sichtbar-Filters die Wellenlänge des abgestrahlten Lichtes sowie seine Halbwertsbreite eingestellt werden. Beispielsweise ist er nur für grünes Licht im Wellenlängenbereich zwischen 490 nm bis 545 nm durchlässig. Vorzugsweise verhindert er damit auch, dass UV-Strahlung, die für das menschliche Auge schädlich ist, nach außen dringt. Zum anderen wird durch die Reflexion von Strahlung, die nicht im gewünschten abzustrahlenden Wellenlängenbereich liegt, die Konversionseffizienz des Bauelements und damit die abgestrahlte Leistung erhöht. Insbesondere wird unkonvertierte UV-Strahlung zurück in den Wellenlängenkonverter reflektiert und kann dort in sichtbares Licht konvertiert werden.

In einer besonders vorteilhaften Ausführungsform weist das optoelektronische Bauelement sowohl einen UV-Filter als auch einen Sichtbar-Filter auf.

Beispielsweise sind einer oder beide dieser Filter als Bragg-Spiegel ausgeführt. Ein Bragg-Spiegel setzt sich aus dielektrischen Schichten mit alternierend hohem und niedrigem Brechungsindex zusammen. Beispielweise kann eine dielektrische Schicht Titandioxid (TiO₂), Siliziumdioxid (SiO₂), Aluminiumoxid (Al₂O₃), Siliziumnitrid (SiN), Tantalpentoxid (Ta₂O₅) oder Hafniumoxid (HfO₂) enthalten.

In einer Ausführungsform sind einer oder beide dieser Filter auf Trägern angeordnet.

Um die optimale Funktionsweise des Filters zu ermöglichen, sollte die Oberfläche des Trägers möglichst eben sein.

Vorzugsweise weist der Träger eine hohe thermische Leitfähigkeit auf und ermöglicht so eine Abführung der in der UV-LED und im Konverter erzeugten Wärme. Beispielsweise enthält der Träger Siliziumcarbid mit einer Leitfähigkeit von zirka 200 W/mK. Besonders vorteilhaft ist ein derartiger Träger für den UV-Filter, da sich dieser in der Umgebung der UV-LED befindet. Der Träger kann ebenfalls eines oder mehrere der Materialien enthalten, die sich als Matrixmaterial für den Wellenlängenkonverter eignen.

In einer bevorzugten Ausführungsform sind einer oder beide dieser Träger monolithisch in den Wellenlängenkonverter integriert. Das heißt, Träger und Wellenlängenkonverter sind mechanisch fest miteinander verbunden. Diese Verbindung lässt sich nicht zerstörungsfrei lösen. Träger und Wellenlängenkonverter sind dann einstückig ausgebildet. Insbesondere kann der Wellenlängenkonverter zugleich den Träger für die Filter darstellen. Dies ermöglicht eine besonders platzsparende Anordnung der Filter und des Wellenlängenkonverters. Zudem ist bei einer gleichzeitigen Nutzung des Wellenlängenkonverters als Träger für die Filter die Herstellung der Anordnung besonders kostengünstig.

Vorzugsweise ist der UV-Filter mit der UV-LED fest verbunden.

In einer Ausführungsform wird der UV-Filter mittels eines Verbindungsmaterials an einer strahlungsemittierenden Vorderseite der UV-LED befestigt. Geeignete Verbindungsmaterialien sind transparente Materialien wie Silikonkleber oder ein Vergussmaterial.

In einer anderen Ausführungsform ist der UV-Filter monolithisch in eine strahlungsemittierende Vorderseite der UV-LED integriert. Der UV-Filter kann dazu mittels Verfahren hergestellt werden, die auch zur Herstellung des Halbleiterkörpers verwendet werden oder mit diesen gut kompatibel sind. Derartige Verfahren sind beispielsweise Sputtern oder epitaktisches Aufwachsen. Somit wird der Herstellungsprozess des Filters technisch vereinfacht.

Weiterhin wird ein optoelektronisches Modul aus den oben genannten Bauelementen angegeben, das mindestens zwei UV-LEDs enthält. Im Strahlengang der erzeugten UV-Strahlung befindet sich mindestens ein Wellenlängenkonverter. In einer bevorzugten Ausführungsform des optoelektronischen Bauelements ist im Strahlengang mindestens ein Filter angeordnet, der für eine der beiden Strahlungsarten ein hohes Transmissionsvermögen und für die andere Strahlungsart ein hohes Reflexionsvermögen aufweist.

Vorzugsweise sind die UV-LEDs in einer Ebene angeordnet und weisen die gleiche Hauptabstrahlrichtung auf. Beispielsweise sind die UV-LEDs als regelmäßiges Gitter angeordnet. Der Wellenlängenkonverter ist vorzugsweise als eine ebene Schicht ausgeführt, die den UV-LEDs in Hauptabstrahlrichtung nachgeordnet ist und diese überdeckt.

Vorzugsweise sind zwischen den UV-LEDs und dem Wellenlängenkonverter ein oder mehrere UV-Filter angeordnet und zwischen dem Wellenlängenkonverter und einer Auskoppelfläche des optoelektronischen Moduls mindestens ein Sichtbar-Filter.

Durch die Kombination mehrerer UV-LEDs wird die Helligkeit der Lichtquelle erhöht. Dabei kann die Herstellung des Moduls und dessen Einbau in ein Gehäuse, beispielsweise in ein Projektorgehäuse, technisch einfach und kostengünstig realisiert werden.

In einer bevorzugten Ausführungsform strahlen alle UV-LEDs in einen gemeinsamen Wellenlängenkonverter und einen gemeinsamen UV-Filter ein. Das konvertierte Licht passiert vorzugsweise einen gemeinsamen Sichtbar-Filter. Dabei können diese Bauelemente direkt aneinander angrenzen und beispielsweise fest miteinander verbunden sein. Insbesondere können die Filter monolithisch in den Wellenlängenkonverter integriert sein. Der gemeinsame UV-Filter kann mittels eines Verbindungsmaterials, beispielsweise eines Silikonklebers oder eines Vergussmaterials, an den UV-LEDs befestigt werden.

In einer bevorzugten Ausführungsform sind ein gemeinsamer UV-Filter und ein gemeinsamer Sichtbar-Filter jeweils als ebene Schichten ausgeführt. Dabei ist der UV-Filter den UV-LEDs in Hauptabstrahlrichtung nachgeordnet und überdeckt diese möglichst vollständig. Der Sichtbar-Filter ist dem Wellenlängenkonverter in Hauptabstrahlrichtung der UV-LEDs nachgeordnet und überdeckt diesen ebenfalls möglichst vollständig.

Derartige gemeinsame Bauelemente können technisch einfacher und kostengünstiger hergestellt werden, als separate Bauelemente. Zudem weist ein großes gemeinsames Bauelement eine höhere mechanische Stabilität auf. Es kann technisch einfacher und kostengünstiger an einem Gehäuse angebracht werden.

In einer beanspruchten Ausführungsform ist ein gemeinsamer Sichtbar-Filter vom Wellenlängenkonverter beabstandet. Im Zwischenraum kann sich ein Luftspalt oder ein Vergussmaterial befinden. Mittels eines solchen Zwischenraums kann die Wärme, die in den UV-LEDs entsteht, besser abgeführt werden.

In einer anderen Ausführungsform weisen die UV-LEDs jeweils separate UV-Filter, separate Wellenlängenkonverter und separate Sichtbar-Filter auf. Diese Anordnung hat den Vorteil, dass die Leuchtdiodenchips flexibler montiert werden können, beispielsweise auch auf gekrümmte Oberflächen. Vorzugsweise befinden sich zwischen den Bauelementen mit Luft oder einem Vergussmaterial gefüllte Zwischenräume, die eine gute Wärmeableitung ermöglichen.

Weitere Ausführungsformen des optoelektronischen Moduls weisen eine Kombination aus Bauelementen auf, die für mehrere UV-LEDs gemeinsam sind, und aus Bauelementen, die für einige UV-LEDs separat vorhanden sind. Beispielsweise können sich mehrere UV-LEDs einen UV-Filter teilen und andere UV-LEDs separate UV-Filter aufweisen.

Beispielsweise können in einer Ausführungsform die UV-Filter und Wellenlängenkonverter separat und der Sichtbar-Filter als gemeinsamer Filter ausgeführt sein. Die UV-Filter können dabei monolithisch in die UV-LEDs integriert sein. Zudem können sie auf ihrer der UV-LED abgewandten Seite direkt an den Wellenlängenkonverter angrenzen und insbesondere in ihn monolithisch integriert sein. In einer anderen Ausführungsform sind sie vom Wellenlängenkonverter beabstandet. Der Sichtbar-Filter kann ebenfalls an einen Wellenlängenkonverter angrenzen, insbesondere monolithisch in ihn integriert sein oder auch von ihm beabstandet sein. Die vorhandenen Zwischenräume können mit Luft oder einem Vergussmaterial gefüllt sein.

Das beschriebene optoelektronische Modul in seinen verschiedenen Ausführungsformen kann beispielsweise als Lichtquelle in einer Projektionsvorrichtung eingesetzt werden. Ein derartiges optoelektronisches Modul kann durch die Verwendung hinreichend vieler UV-LEDs eine große Lichtemissionsfläche aufweisen. Das Modul erzeugt, wie auch das optoelektronische Bauelement mit einer einzigen UV-LED, einen hohen Lichtstrom bei guter Hochstromeffizienz. Zur optimalen Wärmeableitung können in das Modul Zwischenräume eingebracht sein, die mit Luft oder einem Vergussmaterial gefüllt sind. Zudem kann das Modul in den Rahmen integriert werden, wodurch ebenfalls die Wärmeableitung verbessert werden kann.

Gemäß zumindest einer Ausführungsform des optoelektronischen Moduls wird vom Modul monochromatische grüne Strahlung im Wellenlängenbereich von 490 nm bis 575 nm abgestrahlt.

Gemäß zumindest einer Ausführungsform des optoelektronischen Moduls wird vom Modul monochromatische blaue Strahlung im Wellenlängenbereich von 420 nm bis 490 nm abgestrahlt.

Gemäß zumindest einer Ausführungsform des optoelektronischen Moduls wird vom Modul monochromatische gelbe oder rote Strahlung im Wellenlängenbereich von 575 nm bis 750 nm abgestrahlt abgestrahlt.

Gemäß zumindest einer Ausführungsform des optoelektronischen Moduls weist mindestens ein Leuchtdiodenchip einen separaten Wellenlängenkonverter auf.

Gemäß zumindest einer Ausführungsform des optoelektronischen Moduls weisen mindestens zwei, insbesondere alle, Leuchtdiodenchips einen gemeinsamen UV-Filter auf.

Gemäß zumindest einer Ausführungsform des optoelektronischen Moduls weist mindestens ein Leuchtdiodenchip einen separaten UV-Filter auf.

Gemäß zumindest einer Ausführungsform des optoelektronischen Moduls weisen mindestens zwei, insbesondere alle, Leuchtdiodenchips einen gemeinsamen Sichtbar-Filter auf.

Gemäß zumindest einer Ausführungsform des optoelektronischen Moduls weist mindestens ein Leuchtdiodenchip einen separaten Sichtbar-Filter auf.

Im Folgenden werden der angegebene Halbleiterchip und seine vorteilhaften Ausgestaltungen anhand von schematischen und nicht maßstabsgetreuen Figuren erläutert. Es zeigen:
- Figur 1: die Linearitätsfaktoren L_{80/20} verschiedener LEDs in Abhängigkeit von der Hauptwellenlänge λ_{Peak} des emittierten Lichtes,
- Figur 2: die abgestrahlten Lichtleistungen P als Funktionen der Betriebsströme I für eine UV-LED und eine grüne LED,
- Figur 3A: die Lichtströme Φ als Funktionen der Betriebsströme I für eine UV-LED mit Wellenlängenkonverter und für eine grüne LED,
- Figur 3B: die Hauptwellenlängen λ_{Peak} als Funktionen der Betriebsströme I für eine UV-LED mit Wel.lenlängenkonverter und eine grüne LED,
- Figur 4A: im Querschnitt eine Anordnung eines UV-Filters, eines Wellenlängenkonverters und eines GrünFilters,
- Figur 4B: im Querschnitt eine Anordnung eines UV-Filters mit Träger, eines Wellenlängenkonverters und eines Grün-Filters mit Träger,
- Figur 5: im Liniendiagramm das Transmissions- und das Reflexionsvermögen eines UV-Filters für Licht mit unterschiedlichen Wellenlängen λ bei unterschiedlichen Einfallswinkeln α,
- Figur 6A: im Querschnitt ein optoelektronisches Modul mit einem gemeinsamen Konverter, einem gemeinsamen UVFilter und einem gemeinsamen Grün-Filter,
- Figur 6B: Aufsicht auf das optoelektronische Modul gemäß Figur 6A,
- Figur 7A: im Querschnitt ein optoelektronisches Modul mit separaten Wellenlängenkonvertern, separaten UVFiltern und separaten Grün-Filtern,
- Figur 7B: Aufsicht auf das optoelektronische Modul gemäß Figur 7A,
- Figur 8A: im Querschnitt ein optoelektronisches Modul mit einem gemeinsamen Wellenlängenkonverter, einem UVFilter und einem vom Konverter beabstandeten gemeinsamen Grün-Filter,
- Figur 8B: im Querschnitt ein optoelektronisches Modul mit separaten Wellenlängenkonvertern, separaten UVFiltern und einem vom Konverter beabstandeten gemeinsamen Grün-Filter,
- Figur 9A: im Querschnitt ein optoelektronisches Modul mit einem gemeinsamen Wellenlängenkonverter, separaten UV-Filtern, die monolithisch in die UV-LEDs integriert sind und einem gemeinsamen Grün-Filter,
- Figur 9B: im Querschnitt ein optoelektronisches Modul gemäß Figur 9A, wobei die Filter jeweils vom Wellenlängenkonverter in Abstrahlrichtung beabstandet sind,
- Figur 10A: im Querschnitt ein optoelektronisches Bauelement ohne Filter,
- Figur 10B: im Querschnitt ein optoelektronisches Bauelement mit einem UV-Filter,
- Figur 10C: im Querschnitt ein optoelektronisches Bauelement mit einem Grün-Filter,
- Figur 10D: im Liniendiagramm die strahlenden Effizienzen E der Bauelemente gemäß den Figuren 10A, 10B und 10C als Funktionen der Phosphorkonzentrationen C,
- Figur 11: eine schräge Aufsicht auf eine Projektionsvorrichtung mit einem optoelektronischen Modul als Lichtquelle.

In den abgebildeten Figuren liegen die Wellenlängenkonverter 2, die UV-Filter 3 und die Sichtbar-Filter 4 in verschiedenen Ausführungen vor. Zu den Bezugszeichen ist jeweils der Buchstabe a hinzugefügt, falls sich mehrere Leuchtdiodenchips 1 einen gemeinsamen Wellenlängenkonverter 2a oder einen gemeinsamen Filter 3a, 4a teilen. Falls ein Leuchtdiodenchip 1 einen separaten Wellenlängenkonverter 2b oder separate Filter 3b, 4b aufweist, so ist der Buchstabe b hinzugefügt.

In den in den folgenden Figuren beschriebenen Ausführungsbeispielen liegen grüne InGaN-LEDs und UV-InGaN-LEDs in einer Standardbauform vor. Zudem wird ein Grün-Filter eingesetzt. Dies soll jedoch in keiner Weise eine Beschränkung auf InGaN-LEDs und die Erzeugung von grünem Licht darstellen. Vielmehr können in analoger Weise LEDs mit anderen Halbleiterschichtenfolgen und anderen Bauformen eingesetzt werden. Zudem kann die emittierte Strahlung eine andere Wellenlänge aufweisen, zum Beispiel Strahlung im blauen, roten oder gelben Wellenlängenbereich.

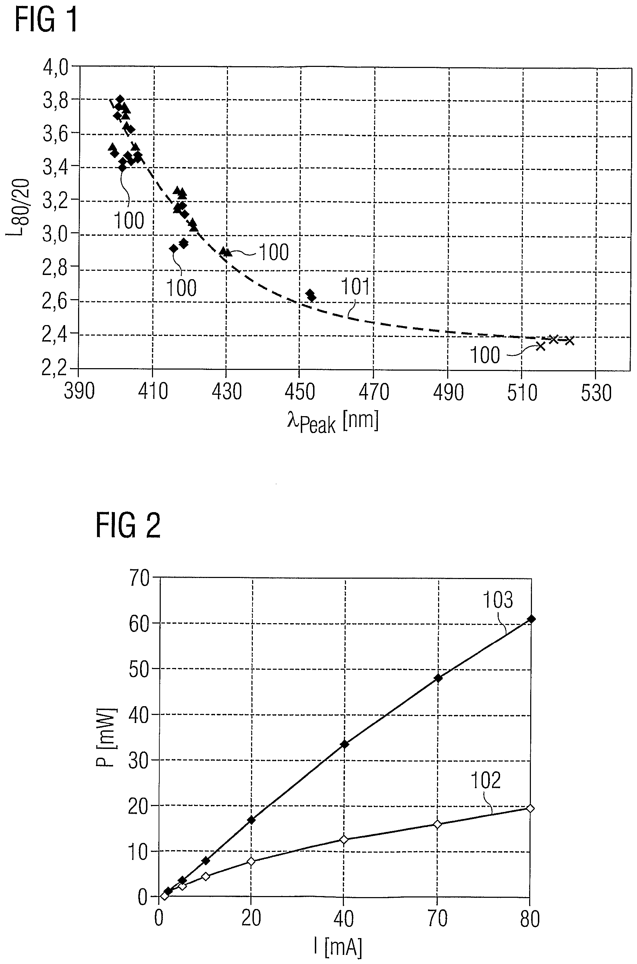

In Figur 1A sind für verschiedene InGaN-LEDs in Standardbauform jeweils der Linearitätsfaktor L_{80/20} gegen die Hauptwellenlänge λ_{Peak} des emittierten Lichtes aufgetragen. Durch die sich ergebenden Messwerte 100 für die einzelnen LEDs wurde eine Ausgleichskurve 101 gelegt.

Der Linearitätsfaktor L_{80/20} ist ein Maß für die Hochstromeffizienz der LED und ist definiert als das Verhältnis der abgestrahlten Leistungen bei Betriebsströmen I = 80 mA und I = 20 mA. Im Idealfall entspricht dieser Faktor dem Verhältnis der beiden Betriebsströme und sollte damit nahe an einem Wert von 4 liegen.

Die hier vermessenen LEDs erzeugen Licht mit Hauptwellenlängen λ_{Peak} im Bereich von 400 nm bis 525 nm. In Figur 1 ist zu sehen, dass in Richtung größerer Wellenlängen die Hochstromeffizienz deutlich abnimmt. Beispielsweise ist bei einer Wellenlänge im Bereich von 400 nm, das heißt für violette Strahlung, L_{80/20} im Bereich von 3,4 bis 3,8. Bei einer Wellenlänge von 420 nm, das heißt für blaue Strahlung, ist L_{80/20} auf einen Wert im Bereich von 2,9 bis 3,3 abgesunken. Bei Wellenlängen im Bereich von 520 nm, das heißt für grüne Strahlung, liegt L_{80/20} unter einem Wert von 2,4.

In Figur 2 sind für eine grüne InGaN-LED 102 mit λ_{Peak} = 525 nm und für eine UV-InGaN-LED 103 mit λ_{Peak} = 400 nm die abgestrahlten Lichtleistungen P in mW gegen die Betriebsströme I für 0 mA ≤ I ≤ 80 mA aufgetragen.

Aus Figur 2 geht zum einen die bessere interne Effizienz der UV-LED 103 hervor. Im gesamten Bereich des Betriebsstroms liegt die Lichtleistung der UV-LED 103 über der Lichtleistung der grünen LED 102. Beispielsweise ist bei einem Betriebsstrom von I = 80 mA die Lichtleistung der UV-LED 103 dreimal so hoch wie die Lichtleistung der grünen LED 102. Zudem zeigt Figur 2 die deutlich bessere Hochstromeffizienz der UV-LED 103. Während sich bei der grünen LED 102 die Lichtleistung von I = 20 mA zu I = 80 mA etwas mehr als verdoppelt, verdreifacht sich die Lichtleistung der UV-LED 103.

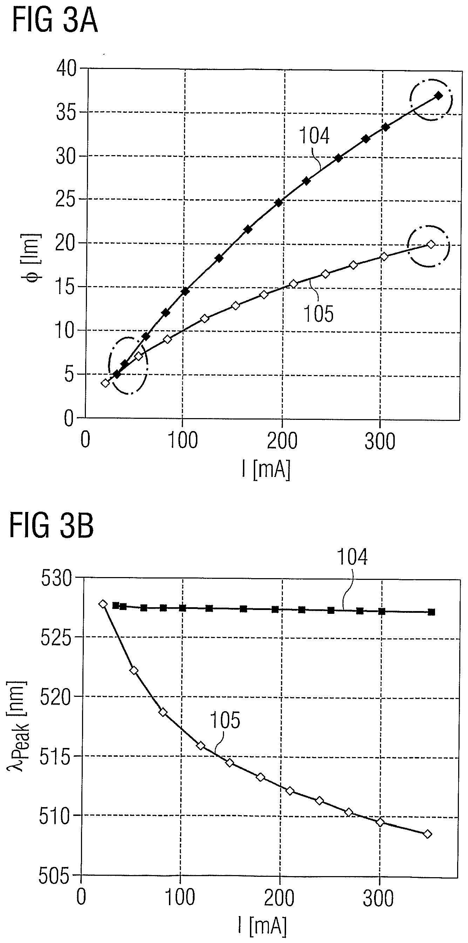

In Figur 3A sind für eine UV-LED mit Wellenlängenkonverter 104, im Folgenden als Konverter-LED bezeichnet, und für eine grüne LED 105 die Lichtströme *φ* in Lumen gegen die Betriebströme I in mA aufgetragen. Der Lichtstrom *φ* ist ein Maß für die mit der Augenempfindlichkeit bewertete Helligkeit einer Lichtquelle. Zur Berechnung von *φ* wird die Ausgangsleistung der LED in einem bestimmten Spektralbereich mit der Augenempfindlichkeit in diesem Spektralbereich multipliziert und anschließend das Integral über den gesamten Spektralraum gebildet.

Die Konverter-LED 104 strahlt Licht mit einer Hauptwellenlänge λ_{Peak} = 527 nm ab. Im gesamten vermessenen Strombereich von 20 mA ≤ I ≤ 350 mA ist der von der Konverter-LED 104 erzeugte Lichtstrom *φ* größer, als derjenige der grünen LED 105. Während bei einem Betriebsstrom von I = 50 mA die Lichtströme *φ* der beiden LEDs bei ähnlichen Werten liegen, ist bei einem Betriebsstrom von I = 350 mA der Abstand der Kurven 104, 105 deutlich größer. Zur Verdeutlichung sind diese Bereiche in Figur 3A eingekreist. Bei einem Betriebsstrom von I = 350 mA weist die Konverter-LED 104 einen Lichtstrom *φ* auf, der um 85 % größer ist, als der Lichtstrom *φ* der grünen LED 105. Zudem ist der Linearitätsfaktor L_{80/20} für die Konverter-LED 104 mit L_{80/20} = 3,35 wesentlich günstiger als für die grüne LED 105 mit L_{80/20} = 2,25.

In Figur 3B sind für die LEDs 104, 105 gemäß Figur 3A die Hauptwellenlängen λ_{Peak} gegen die Betriebsströme I in mA aufgetragen.

Für beide LEDs 104, 105 weist das abgestrahlte Licht bei I ≈ 20 mA eine Hauptwellenlänge von λ_{Peak} ≈ 528 nm auf. Bei der grünen LED 105 verschiebt sich die Hauptwellenlänge bei einer Erhöhung des Betriebsstroms in Richtung kürzerer Wellenlängen. Bei der Konverter-LED 104 jedoch nimmt die Hauptwellenlänge zwischen 20 mA und 350 mA nur wenig ab. Bei I = 350 mA ist die Hauptwellenlänge λ_{Peak} ≈ 526 nm.

Die Figuren 3A und 3B haben somit gezeigt, dass die Konverter-LED 104 im Vergleich zur grünen LED 105 günstigere Eigenschaften sowohl im Hinblick auf die Hochstromeffizienz und als auch im Hinblick auf den Wellenlängenshift aufweist.

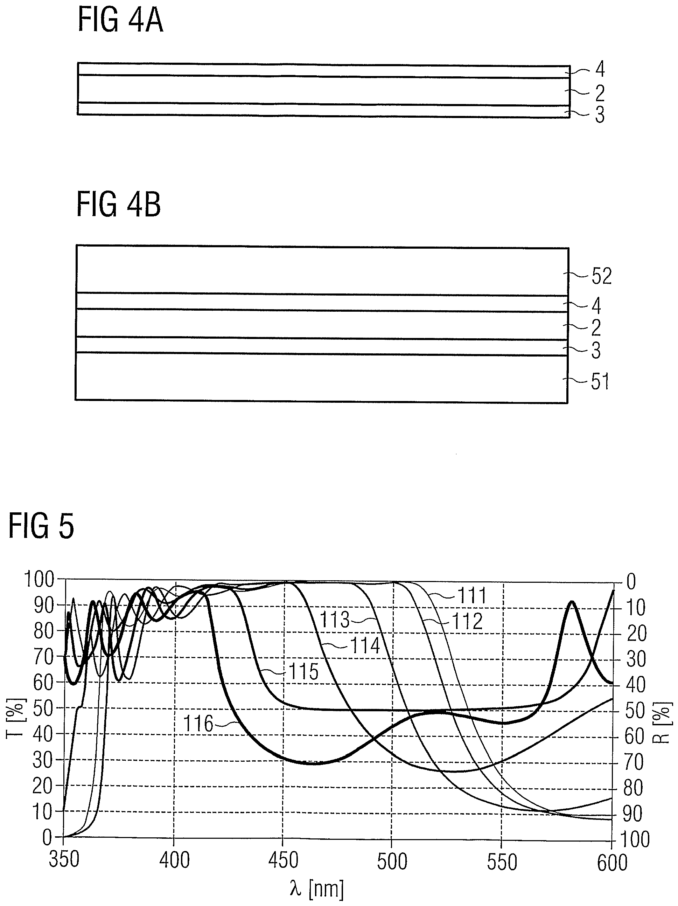

Figur 4A zeigt eine Anordnungsmöglichkeit für einen Wellenlängenkonverter 2, einen UV-Filter 3 und einen Grün-Filter 4. Der Wellenlängenkonverter 2 befindet sich zwischen den beiden Filtern 3, 4. Wird diese Anordnung in einer Konverter-LED eingesetzt, befindet sich eine UV-LED an der Seite des UV-Filters 3, die dem Wellenlängenkonverter 2 abgewandt ist.

In Figur 4B ist eine Anordnung dargestellt, die der in Figur 4A gezeigten Anordnung von Wellenlängenkonverter 2, UV-Filter 3 und Grün-Filter 4 entspricht. Hier sind jedoch beide Filter 3, 4 auf Trägern 51, 52 angeordnet. Alternativ dazu kann auch nur einer der Filter 3, 4 auf einem Träger 51, 52 angeordnet sein. Abweichend von der hier gezeigten Anordnung können die Filter 3, 4 auch auf den Seiten der Träger 51, 52 angeordnet sein, die dem Wellenlängenkonverter 2 abgewandt sind. Vorzugsweise weist das Trägermaterial eine hohe thermische Leitfähigkeit auf und kann dadurch die entstehende Wärme gut abführen. Insbesondere ist es vorteilhaft, zumindest den UV-Filter 3 auf einem Träger 51 anzuordnen, um die in der UV-LED entstehende Wärme abzuführen.

In Figur 5 sind das Transmissionsvermögen T und das Reflexionsvermögen R eines UV-Filters als Funktionen der Wellenlänge λ der auf ihn treffenden Strahlung aufgetragen. Da die Werte stark vom Einfallswinkel abhängen, unter dem die Strahlung auf den UV-Filter trifft, sind T und R für sechs verschiedene Einfallswinkel in sechs Kurven dargestellt. Dabei entsprechen die Kurven 111, 112, 113, 114, 115 und 116 den Einfallswinkeln 0°, 15°, 30°, 45°, 60° und 70°. In einem Bereich von 380 nm ≤ λ ≤ 420 nm liegt für alle Einfallswinkel das Transmissionsvermögen bei T ≈ 90 %. Für alle anderen Wellenlängenbereiche liegt das Transmissionsvermögen für mehrere Einfallswinkel deutlich unter diesem Wert.

Das Reflexionsvermögen R ergibt sich aus dem Transmissionsvermögen T bei einer vorliegenden Absorption A des Filters zu R = 100 % - T - A. Da die Absorption des hier vermessenen Filters vernachlässigbar ist, ergibt sich die Reflexion R direkt aus R = 100 % - T und geht ebenfalls aus Figur 5 hervor. Für Wellenlängen im Bereich zwischen 525 nm und 570 nm wird für fast alle Einfallswinkel mindestens 45 % des auftreffenden Lichtes reflektiert.

Der vorliegende Filter besitzt also selektiv für grünes Licht, zum Beispiel für λ = 525 nm, ein hohes Reflexionsvermögen und selektiv für UV-Strahlung, zum Beispiel für λ = 400 nm, ein hohes Transmissionsvermögen und wird deshalb als UV-Filter bezeichnet.

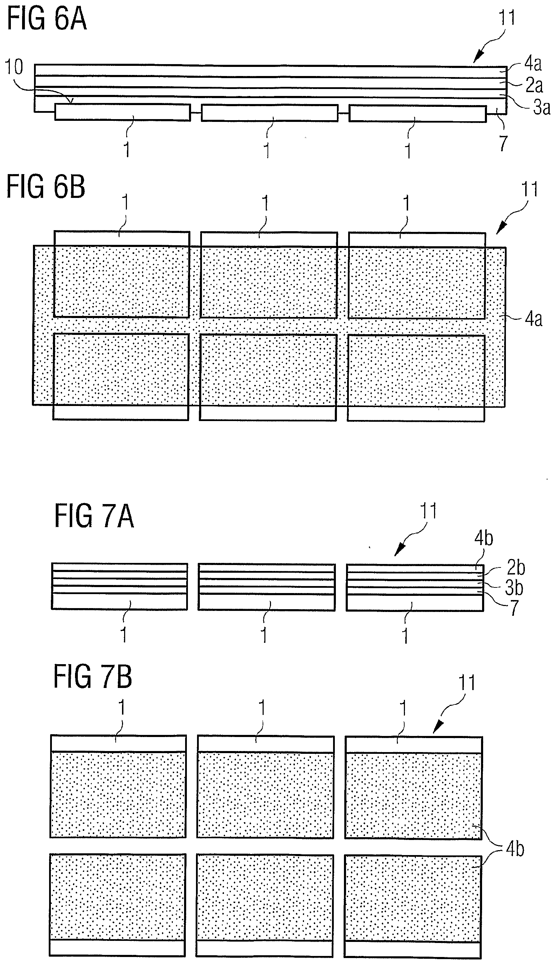

In den Figuren 6A, 6B, 7A, 7B, 8A, 8B, 9A und 9B sind verschiedene Ausführungsbeispiele für ein optoelektronisches Modul schematisch dargestellt. Alle gezeigten Bauelemente weisen sechs UV-LEDs 1 auf. Ein oder mehrere Wellenlängenkonverter 2a, 2b wandeln die UV-Strahlung in Strahlung einer größeren Wellenlänge, hier in grünes Licht, um.

Zwischen jedem Leuchtdiodenchip 1 und jedem Wellenlängenkonverter 2a, 2b befindet sich mindestens ein UV-Filter 3a, 3b, der für die UV-Strahlung durchlässig ist und grüne Strahlung reflektiert. In einer bevorzugten Ausführungsform weist dieser Filter ein Transmissions- und Reflexionsvermögen gemäß Figur 5 auf. Soll sichtbares Licht mit einer anderen Wellenlänge emittiert werden, kann ein Filter mit einem anderen Reflexionsverhalten eingesetzt werden. An der Seite des Wellenlängenkonverters 2a, 2b, der den Leuchtdiodenchips 1 abgewandt ist, befindet sich mindestens ein Grün-Filter 4a, 4b, der für das grüne Licht durchlässig ist und die UV-Strahlung reflektiert. In weiteren Ausführungsformen kann ein optoelektronisches Modul nur eine Sorte von Filtern umfassen.

Figur 6A zeigt im Querschnitt ein optoelektronisches Modul 11, bei dem sich alle UV-LEDs 1 einen gemeinsamen UV-Filter 3a, einen gemeinsamen Grün-Filter 4a, sowie einen gemeinsamen Wellenlängenkonverter 2a teilen. Hier sind die Bauelemente 3a, 4a,' und 2a als ebene Schichten ausgeführt, die direkt aneinander angrenzen. Der UV-Filter 3a wird mittels eines Verbindungsmaterials 7, das zum Beispiel ein Silikonkleber oder ein Vergussmaterial sein kann, an strahlungsemittierenden Vorderseiten 10 der UV-LEDs 1 befestigt.

Figur 6B zeigt eine Aufsicht auf dieses Modul 11. Hier sind die sechs UV-LEDs 1 sowie der gemeinsame Grün-Filter 4a zu erkennen, der die UV-LEDs 1 fast vollständig abdeckt.

In Figur 7A ist im Querschnitt ein Ausführungsbeispiel eines Moduls 11 zu sehen, bei dem jede UV-LED 1 einen separaten UV-Filter 3b, einen separaten Grün-Filter 4b sowie einen separaten Wellenlängenkonverter 2b aufweist. Diese Elemente sind analog zu Figur 6A als ebene Schichten ausgeführt und grenzen direkt aneinander an. Die separaten UV-Filter 3b sind auch hier mittels eines Verbindungsmaterials 7 an den UV-LEDs 1 befestigt.

Figur 7B zeigt die Aufsicht auf das Modul 11 gemäß Figur 7A, bei dem die separaten Grün-Filter 4b zu sehen sind, die die UV-LEDs 1 bis auf die Kontaktbereiche abdecken.

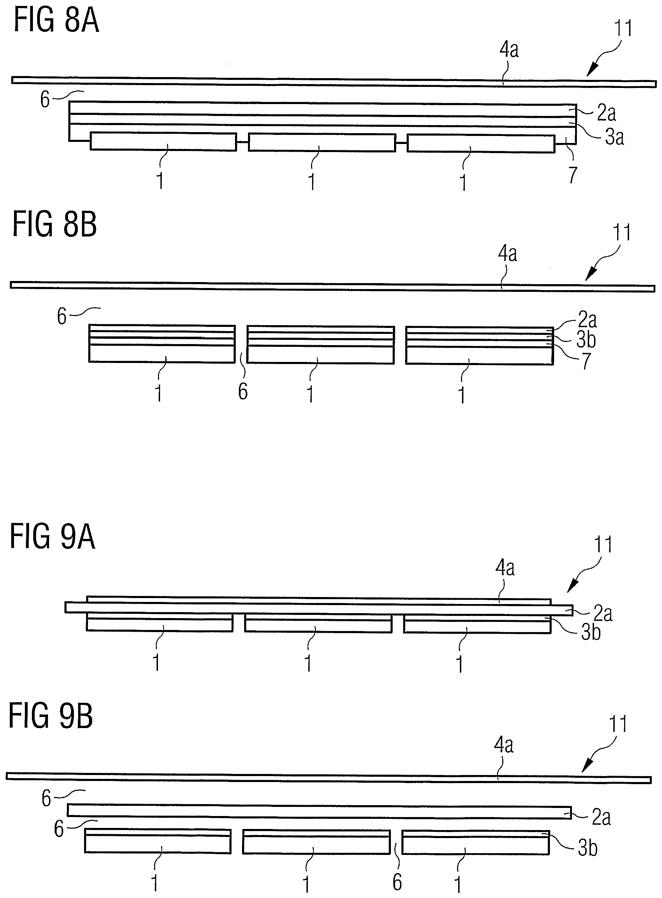

In Figur 8A ist ein Ausführungsbeispiel eines Moduls 11 gezeigt, bei dem sich alle UV-LEDs 1 einen gemeinsamen Wellenlängenkonverter 2a, einen gemeinsamen UV-Filter 3a und einen gemeinsamen Grün-Filter 4a teilen. Der UV-Filter 3a ist mittels eines Verbindungsmaterials 7 an den UV-LEDs 1 befestigt. Der Grün-Filter 4a ist vom Wellenlängenkonverter 2a beabstandet. Der vorhandene Zwischenraum 6 ist beispielsweise ein Luftspalt oder ist mit einem Vergussmaterial gefüllt.

Figur 8B zeigt ein weiteres Ausführungsbeispiel eines Moduls 11, bei dem sich wie in Figur 8A alle UV-LEDs 1 einen gemeinsamen UV-Filter 4a teilen, der von den Wellenlängenkonvertern 2b beabstandet ist. Im Unterschied zu Figur 8A weisen hier jedoch die UV-LEDs 1 separate UV-Filter 3b und separate Wellenlängenkonverter 2b auf.

Figur 9A zeigt ein Ausführungsbeispiel für ein Modul 11 mit einem gemeinsamen Wellenlängenkonverter 2a, einem gemeinsamen Grün-Filter 4a und separaten UV-Filtern 3b. Die separaten UV-Filter 3b und der gemeinsame Grün-Filter 4a grenzen jeweils direkt an den Wellenlängenkonverter 2a an. Im Unterschied zu allen bisher gezeigten Ausführungsbeispielen sind die separaten UV-Filter 3b monolithisch in die UV-LEDs 1 integriert.

In Figur 9B ist ein weiteres Ausführungsbeispiel für ein Modul 11 dargestellt, dass sich von der in Figur 9A gezeigten Anordnung durch die zusätzlichen Zwischenräume 6 zwischen den UV-Filtern 3b und dem Wellenlängenkonverter 2a sowie dem Grün-Filter 4a und dem Wellenlängenkonverter 2a unterscheidet. Diese Zwischenräume 6 können Luft oder ein Vergussmaterial enthalten.

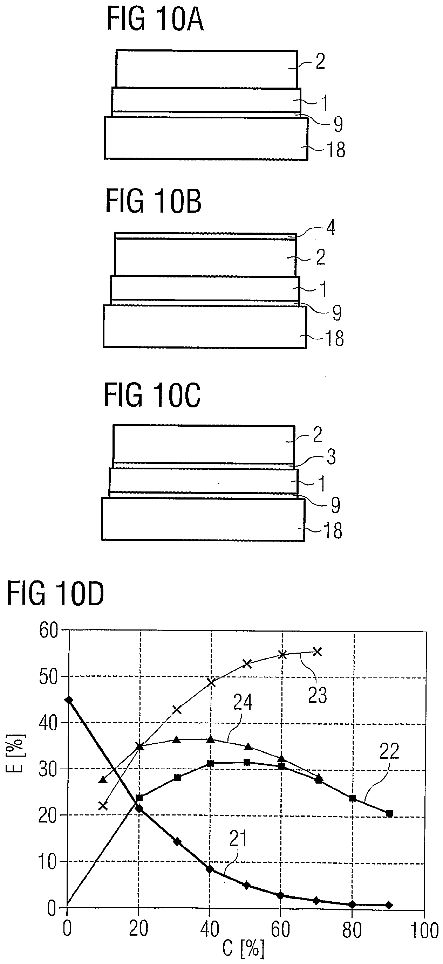

In den Figuren 10A, 10B und 10C sind im Querschnitt verschiedene optoelektronische Bauelemente dargestellt, deren strahlende Effizienzen E berechnet wurden und in Figur 10D aufgetragen sind.

In Figur 10A ist eine UV-LED 1 mit einem Wellenlängenkonverter 2 auf einem Hilfsträger 18, beispielsweise mittels einer Lotverbindung 9, aufgebracht. Das gezeigte optoelektronische Bauelement weist keinen Filter auf. In Figur 10B befindet sich zusätzlich ein Grün-Filter 4 an der der UV-LED 1 abgewandten Seite des Wellenlängenkonverters 2. In Figur 10C befindet sich stattdessen ein UV-Filter 3 zwischen dem Wellenlängenkonverter 2 und der UV-LED 1.

Die strahlenden Effizienzen E dieser Anordnungen wurden in Abhängigkeit von der Phosphorkonzentration C im jeweiligen Wellenlängenkonverter 2 berechnet.

In Figur 10D sind die berechneten strahlenden Effizienzen für grünes Licht 22, 23, 24 in % einer maximalen strahlenden Effizienz gegen die Phosphorkonzentration C in % einer Maximalkonzentration aufgetragen. Für die Anordnung gemäß Figur 10A ist zusätzlich die strahlende Effizienz für unkonvertierte UV-Strahlung 21 aufgetragen.

Bei der in Figur 10A gezeigten Anordnung wird bei einer verschwindenden Phosphorkonzentration C erwartungsgemäß kein grünes Licht emittiert und die strahlende Effizienz 22 liegt bei 0 %. Hingegen wird zirka 45 % der in der UV-LED 1 erzeugten UV-Strahlung 21 ausgekoppelt. Die strahlende Effizienz E für die UV-Strahlung 21 nimmt bei steigender Phosphorkonzentration ab und ist bei C = 90 % nahe bei 0 %. Im Gegensatz dazu steigt E für grünes Licht 22 bei zunehmender Phosphorkonzentration erst an, erreicht bei C = 50 % seinen Maximalwert von E ≈ 31 % und nimmt bei weiter steigendem C langsam ab. Die Abnahme der strahlenden Effizienz 22 lässt sich auf eine Absorption im Wellenlängenkonverter und im LED-Chip zurückführen. Bei C = 90 % liegt die strahlende Effizienz 22 bei E ≈ 20 %.

Durch den Einsatz eines Grün-Filters 4 gemäß Figur 10B erhöht sich die strahlende Effizienz für grünes Licht 24. Dies beruht darauf, dass der Grün-Filter einen Anteil der UV-Strahlung wieder in den Wellenlängenkonverter 2 zurückreflektiert. Hier kann es erneut in grünes Licht umgewandelt werden.

Figur 10D zeigt auch die strahlende Effizienz für grünes Licht 23 bei Vorhandensein eines UV-Filters 3 gemäß Figur 10C. Die strahlende Effizienz 23 ist wesentlich höher als die strahlende Effizienz 24 bei Vorhandensein eines Grün-Filters. In dem betrachteten Bereich von 10 % ≤ C ≤ 70 % steigt bei zunehmender Konzentration C die strahlende Effizienz 23 stetig an und liegt für C = 70 % bei einem Wert von E ≈ 55 %. Dies ist darauf zurückzuführen, dass das grüne Licht vom UV-Filter zurückreflektiert wird und so die Absorption in der UV-LED verringert wird.

Insgesamt geht aus Figur 10 D deutlich hervor, dass sich sowohl durch den Einsatz eines Grün-Filters 4 als auch eines UV-Filters 3 die strahlenden Effizienzen 24, 23 für grünes Licht deutlich erhöhen. Während die strahlende Effizienz 22 für die Anordnung ohne Filter bei einem Maximalwert im Bereich von E ≈ 30 % liegt, ist bei einem Grün-Filter 4 ein Maximalwert von E ≈ 35 % erreicht und bei einem UV-Filter 3 ein Maximalwert von deutlich über 50 %. Es ist zu erwarten, dass sich bei einem gleichzeitigen Einsatz von Grün-Filter 4 und UV-Filter 3 die strahlende Effizienz noch einmal erhöht.

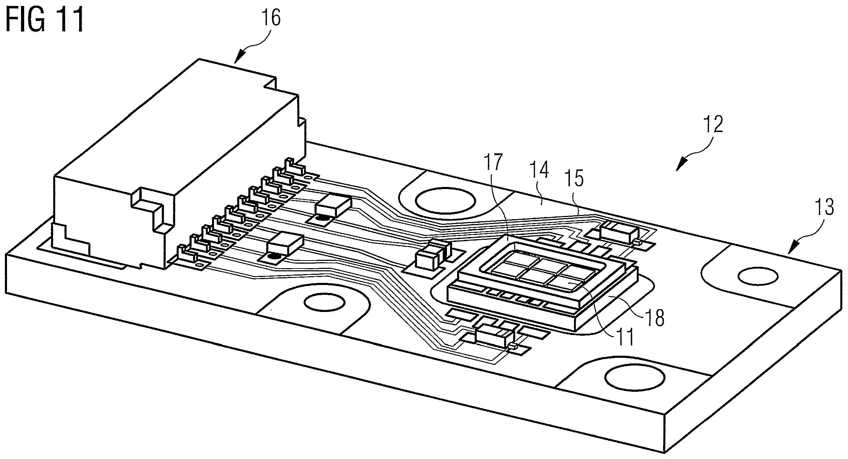

Figur 11 zeigt eine Projektionsvorrichtung 12, bei der ein optoelektronisches Modul 11 zur Lichterzeugung eingesetzt wird. Das optoelektronische Modul 11 weist sechs UV-LEDs 1, sowie die Bauelemente UV-Filter 3, Wellenlängenkonverter 2 und Grün-Filter 4 in einer der Ausführungsformen gemäß den Figuren 6A, 6B, 7A, 7B, 8A, 8B, 9A oder 9B auf. Das optoelektronische Modul 11 ist von einem Rahmen 17 umgeben, der die entstehende Wärme gut abführen kann. Dieser ist auf einem Hilfsträger 18 angeordnet, der sich wiederum auf einem Träger 13 befindet. Auf diesem Träger 13 ist eine Leiterplatte 14 aufgebracht, in die Leiterbahnen 15 zur elektrischen Kontaktierung des optoelektronischen Moduls 11 eingebracht sind. Die Leiterbahnen 15 sind mit einem Stecker 16 verbunden, der elektrisch angeschlossen werden kann.

Die Erfindung ist nicht durch die Beschreibung an Hand der Ausführungsbeispiele auf diese beschränkt, sondern umfasst jedes neue Merkmal sowie jede Kombination von Merkmalen. Dies beinhaltet insbesondere jede Kombination von Merkmalen in den Patentansprüchen, auch wenn dieses Merkmal oder diese Kombination selbst nicht explizit in den Patentansprüchen oder Ausführungsbeispielen angegeben ist.

Diese Patentanmeldung beansprucht die Prioritäten der deutschen Patentanmeldungen DE 102008006974.4 und DE 102008017071.2.

## Patentansprüche

1. Optoelektronisches Modul
- mit mehreren Leuchtdiodenchips (1), die UV-LEDs sind und UV-Strahlung erzeugen,
- mit mindestens einem Wellenlängenkonverter (2), der den Leuchtdiodenchips (1) in Abstrahlrichtung nachgeordnet ist und der die UV-Strahlung wenigstens teilweise in Strahlung im sichtbaren Wellenlängenbereich umwandelt,
- mit einem UV-Filter (3, 3a, 3b), der sich zwischen dem Wellenlängenkonverter (2) und einem der Leuchtdiodenchips (1) befindet, wobei der UV-Filter (3, 3a, 3b) für die UV-Strahlung ein Transmissionsvermögen von wenigstens 50 % und für die Strahlung im sichtbaren Wellenlängenbereich ein Reflexionsvermögen von wenigstens 50 % aufweist,
- mit einem gemeinsamen Sichtbar-Filter (4a) für die Leuchtdiodenchips, der für die Strahlung im sichtbaren Wellenlängenbereich ein Transmissionsvermögen von wenigstens 50 % und für die UV-Strahlung ein Reflexionsvermögen von wenigstens 50 % aufweist, wobei sich der gemeinsame Sichtbar-Filter (4a) zwischen dem Wellenlängenkonverter (2, 2a) und einer Auskoppelfläche des optoelektronischen Moduls befindet,
wobei der gemeinsame Sichtbar-Filter vom Wellenlängenkonverter in Abstrahlrichtung beabstandet ist und sich Luft oder eine Vergussmasse zwischen dem gemeinsamen Sichtbar-Filter und dem Wellenlängenkonverter befindet.

2. Optoelektronisches Modul nach Anspruch 1,
wobei
- das Transmissionsvermögen und das Reflexionsvermögen zwischen einschließlich 50 % und 100 % sind,
- der gemeinsame Sichtbar-Filter (4a) selektiv für das Licht im sichtbaren Bereich durchlässig ist und die UV-Strahlung reflektiert,
- alle Leuchtdiodenchips (1) den Wellenlängenkonverter (2) als gemeinsamen Wellenlängenkonverter (2a) aufweisen,
- der gemeinsame Sichtbar-Filter (4a) als Sichtbar-Filter für alle Leuchtdiodenchips (1) ausgeführt ist, und
- der UV-Filter (3, 3a, 3b) ein gemeinsamer UV-Filter (3a) für alle Leuchtdiodenchips (1) ist.

3. Optoelektronisches Modul nach Anspruch 1,
wobei
- der UV-Filter (3, 3a, 3b) für die UV-Strahlung ein Transmissionsvermögen von wenigstens 90 % und für die Strahlung im sichtbaren Wellenlängenbereich ein Reflexionsvermögen von wenigstens 90 % aufweist, und
- der gemeinsame Sichtbar-Filter (4a) für die Strahlung im sichtbaren Wellenlängenbereich ein Transmissionsvermögen von wenigstens 90 % und für die UV-Strahlung ein von wenigstens 90 % Reflexionsvermögen aufweist.

4. Optoelektronisches Modul nach Anspruch 1,
bei dem der gemeinsame Sichtbar-Filter (4a) als Sichtbar-Filter für alle Leuchtdiodenchips (1) ausgeführt ist.

5. Optoelektronisches Modul nach Anspruch 1,
bei dem der UV-Filter (3, 3a, 3b) ein gemeinsamer UV-Filter (3a) für alle als UV-LEDs ausgeführten Leuchtdiodenchips (1) ist, wobei der gemeinsame UV-Filter (3a) selektiv für die UV-Strahlung durchlässig ist und die Strahlung im sichtbaren Wellenlängenbereich reflektiert.

6. Optoelektronisches Modul nach einem der Ansprüche 1 bis 5,
bei dem alle Leuchtdiodenchips (1) den Wellenlängenkonverter (2) als gemeinsamen Wellenlängenkonverter (2a) aufweisen.

7. Optoelektronisches Modul nach Anspruch 1,
das separate UV-Filter (3b) aufweist, die monolithisch in die als UV-LEDs ausgeführten Leuchtdiodenchips (1) integriert sind, wobei
- der Wellenlängenkonverter (2) ein gemeinsamer Wellenlängenkonverter (2a) für alle Leuchtdiodenchips (1) ist,
- der gemeinsame Sichtbar-Filter (4a) ein gemeinsamer Grün-Filter ist, und
- Zwischenräume (6) zwischen den UV-Filtern (3b) und dem Wellenlängenkonverter (2a) sowie zwischen dem Grün-Filter (4a) und dem Wellenlängenkonverter (2a) vorhanden sind, die Luft oder ein Vergussmaterial enthalten.

8. Optoelektronisches Modul nach Anspruch 1,
das einen gemeinsamen UV-Filter (3a) für alle als UV-LEDs ausgeführten Leuchtdiodenchips (1) aufweist, wobei der gemeinsame UV-Filter und der gemeinsame Sichtbar-Filter (4a) jeweils als ebene Schichten ausgeführt und den UV-LEDs in Hauptabstrahlrichtung nachgeordnet sind, und wobei der gemeinsame UV-Filter und der gemeinsame Sichtbar-Filter die UV-LEDs vollständig überdecken.

9. Optoelektronisches Modul nach Anspruch 1,
bei dem der UV-Filter (3) monolithisch in einen Leuchtdiodenchip (1) integriert ist.

10. Optoelektronisches Modul nach Anspruch 1,
bei dem der UV-Filter (3) von einem Leuchtdiodenchip (1) in Abstrahlrichtung beabstandet ist, wobei sich zwischen dem UV-Filter (3) und dem Leuchtdiodenchip (1) Silikonkleber oder eine Vergussmasse befindet.

11. Optoelektronisches Modul nach Anspruch 1,
bei dem
- alle Leuchtdiodenchips (1) den Wellenlängenkonverter (2) als gemeinsamen Wellenlängenkonverter (2a) aufweisen,
- der gemeinsame Sichtbar-Filter (4a) als Sichtbar-Filter für alle Leuchtdiodenchips (1) ausgeführt ist, und
- der UV-Filter (3, 3a, 3b) ein gemeinsamer UV-Filter (3a) für alle als UV-LEDs ausgeführten Leuchtdiodenchips (1) ist.

12. Optoelektronisches Modul nach Anspruch 1,
mit zumindest drei Leuchtdiodenchips(1), bei dem
- jedem Leuchtdiodenchip (1) ein UV-Filter (3), der UV-Strahlung transmittiert, ein-eindeutig zugeordnet und unmittelbar nachgeordnet ist, wobei jeder Leuchtdiodenchip (1) mit seinem UV-Filter (3) monolithisch integriert ist,
- der Anordnung aus Leuchtdiodenchips (1) und UV-Filtern (3) genau ein Wellenlängenkonverter (2) nachgeordnet ist, und
- dem Wellenlängenkonverter (2) genau ein Sichtbar-Filter (4), nämlich der gemeinsame Sichtbar-Filter (4a), nachgeordnet ist.

13. Projektionsanordnung,
bei der ein optoelektronisches Modul nach einem der Ansprüche 1 bis 12 als Lichtquelle vorgesehen ist.

14. Projektionsanordnung nach Anspruch 13,
bei dem das optoelektronische Modul von einem wärmeleitenden Rahmen (17) umgeben ist.

## Claims

1. An optoelectronic module
- having several light emitting diode chips (1) which are UV LEDs and generate UV radiation,
- having at least one wavelength converter (2) which is arranged downstream of the light-emitting diode chips (1) in direction of emission and which at least partially converts the UV radiation into radiation in the visible wavelength range,
- having a UV filter (3, 3a, 3b) which is located between the wavelength converter (2) and one of the light-emitting diode chips (1), the UV filter (3, 3a, 3b) having a transmittance of at least 50 % for UV radiation and a reflectivity of at least 50 % for radiation in the visible wavelength range,
- having a common visible filter (4a) for the light-emitting diode chips, which has a transmittance of at least 50 % for the radiation in the visible wavelength range and a reflectivity of at least 50 % for the UV radiation, the common visible filter (4a) being located between the wavelength converter (2, 2a) and an output coupling surface of the optoelectronic module,
wherein the common visible filter is spaced apart from the wavelength converter in the direction of radiation and air or a potting compound is located between the common visible filter and the wavelength converter.

2. The optoelectronic module according to claim 1,
wherein
- the transmittance and reflectivity are between 50 % and 100 % inclusive,
- the common visible filter (4a) is selectively transparent to light in the visible range and reflects UV radiation,
- all light emitting diode chips (1) have the wavelength converter (2) as a common wavelength converter (2a),
- the common visible filter (4a) is formed as a visible filter for all light emitting diode chips (1), and
- the UV filter (3, 3a, 3b) is a common UV filter (3a) for all light emitting diode chips (1).

3. The optoelectronic module according to claim 1,
wherein
- the UV filter (3, 3a, 3b) has a transmittance of at least 90 % for UV radiation and a reflectivity of at least 90 % for radiation in the visible wavelength range, and
- the common visible filter (4a) has a transmittance of at least 90 % for radiation in the visible wavelength range and a reflectivity of at least 90 % for UV radiation.

4. The optoelectronic module according to claim 1,
wherein the common visible filter (4a) is formed as a visible filter for all light emitting diode chips (1).

5. The optoelectronic module according to claim 1,
wherein the UV filter (3, 3a, 3b) is a common UV filter (3a) for all light-emitting diode chips (1) formed as UV LEDs, wherein the common UV filter (3a) is selectively transmissive to the UV radiation and reflects the radiation in the visible wavelength range.

6. The optoelectronic module according to any one of claims 1 to 5,
wherein all light-emitting diode chips (1) have the wavelength converter (2) as a common wavelength converter (2a).

7. The optoelectronic module according to claim 1,
which has separate UV filters (3b) which are monolithically integrated into the light-emitting diode chips (1) designed as UV LEDs, wherein
the wavelength converter (2) is a common wavelength converter (2a) for all light emitting diode chips (1), the common visible filter (4a) is a common green filter, and
there are gaps (6) between the UV filters (3b) and the wavelength converter (2a) and between the green filter (4a) and the wavelength converter (2a) which contain air or a potting material.

8. The optoelectronic module according to claim 1,
which has a common UV filter (3a) for all light-emitting diode chips (1) formed as UV LEDs, wherein the common UV filter and the common visible filter (4a) each are formed as planar layers and are arranged downstream of the UV LEDs in the main radiation direction, and wherein the common UV filter and the common visible filter completely cover the UV LEDs.

9. The optoelectronic module according to claim 1,
wherein the UV filter (3) is monolithically integrated into a light-emitting diode chip (1).

10. The optoelectronic module according to claim 1,
wherein the UV filter (3) is spaced apart from a light-emitting diode chip (1) in the direction of radiation, wherein silicone adhesive or a sealing compound is located between the UV filter (3) and the light-emitting diode chip (1).

11. The optoelectronic module according to claim 1,
wherein
- all light emitting diode chips (1) have the wavelength converter (2) as a common wavelength converter (2a),
- the common visible filter (4a) is formed as a visible filter for all light emitting diode chips (1), and
- the UV filter (3, 3a, 3b) is a common UV filter (3a) for all light emitting diode chips (1) formed as UV LEDs.

12. The optoelectronic module according to claim 1, comprising at least three light emitting diode chips(1),
wherein
- each light-emitting diode chip (1) is uniquely assigned and arranged directly downstream to a UV filter (3) transmitting UV radiation, wherein each light-emitting diode chip (1) is monolithically integrated with its UV filter (3),
- the arrangement of light-emitting diode chips (1) and UV filters (3) is followed by exactly one wavelength converter (2), and
- the wavelength converter (2) is followed by exactly one visible filter (4), namely the common visible filter (4a) .

13. A projection arrangement,
wherein an optoelectronic module according to any one of claims 1 to 12 is provided as light source.

14. The projection arrangement according to claim 13,
wherein the optoelectronic module is surrounded by a thermally conductive frame (17).

## Revendications

1. Module optoélectronique
- doté de plusieurs puces de diode électroluminescente (1) qui sont des DEL-UV et qui génèrent un rayonnement UV,
- doté d'au moins un convertisseur de longueur d'onde (2) qui, dans le sens du rayonnement, est agencé en aval des puces de diode électroluminescente (1) et qui convertit au moins partiellement le rayonnement UV en rayonnement en région de longueurs d'ondes visibles,
- doté d'un filtre à UV (3, 3a, 3b) qui se trouve entre le convertisseur de longueur d'onde (2) et une des puces de diode électroluminescente (1), le filtre à UV (3, 3a, 3b) présentant, pour le rayonnement UV, une capacité de transmission d'au moins 50 % et pour le rayonnement en région de longueurs d'ondes visibles, une capacité de réflexion d'au moins 50 %,
- doté d'un filtre de visibilité commun (4a) pour les puces de diode électroluminescente, lequel présente, pour le rayonnement en région de longueurs d'ondes visibles, une capacité de transmission d'au moins 50 % et pour le rayonnement UV une capacité de réflexion d'au moins 50 %, le filtre de visibilité commun (4a) se trouvant entre le convertisseur de longueur d'onde (2, 2a) et une surface de découplage du module optoélectronique,
ledit filtre de visibilité commun étant espacé du convertisseur de longueur d'onde dans le sens du rayonnement, et de l'air ou une pâte de remplissage se trouvant entre le filtre de visibilité commun et le convertisseur de longueur d'onde.

2. Module optoélectronique selon la revendication 1,
dans lequel
- la capacité de transmission et la capacité de réflexion sont de 50 % à 100 % compris,
- le filtre de visibilité commun (4a) est sélectivement perméable à la lumière en région de rayonnement visible et reflète le rayonnement UV,
- toutes les puces de diode électroluminescente (1) présentent le convertisseur de longueur d'onde (2) en tant que convertisseur de longueur d'onde commun (2a),
- le filtre de visibilité commun (4a) est réalisé en tant que filtre de visibilité pour toutes les puces de diode électroluminescente (1), et
- le filtre à UV (3, 3a, 3b) est un filtre à UV commun (3a) pour toutes les puces de diode électroluminescente (1) .

3. Module optoélectronique selon la revendication 1,
dans lequel
- le filtre à UV (3, 3a, 3b) présente, pour le rayonnement UV, une capacité de transmission d'au moins 90 % et pour le rayonnement en région de longueurs d'ondes visibles, une capacité de réflexion d'au moins 90 %, et
- le filtre de visibilité commun (4a) présente, pour le rayonnement en zone de longueur d'onde visible, une capacité de transmission d'au moins 90 % et pour le rayonnement UV, une capacité de réflexion d'au moins 90 %.

4. Module optoélectronique selon la revendication 1,
dans lequel le filtre de visibilité commun (4a) est réalisé en tant que filtre de visibilité pour toutes les puces de diode électroluminescente (1).

5. Module optoélectronique selon la revendication 1,
dans lequel le filtre à UV (3, 3a, 3b) est un filtre à UV commun (3a) pour toutes les puces de diode électroluminescente (1) réalisées en tant que DEL-UV, le filtre à UV commun (3a) étant sélectivement perméable au rayonnement UV et reflètent le rayonnement en région de longueurs d'ondes visibles.

6. Module optoélectronique selon l'une quelconque des revendications 1 à 5,
dans lequel toutes les puces de diode électroluminescente (1) présentent le convertisseur de longueur d'onde (2) en tant que convertisseur de longueur d'onde commun (2a).

7. Module optoélectronique selon la revendication 1,
qui présente des filtres à UV séparés (3b), lesquels sont intégrés de manière monolithique dans les puces de diode électroluminescente (1) réalisées en tant que DEL-UV, dans lequel
- le convertisseur de longueur d'onde (2) est un convertisseur de longueur d'onde commun (2a) pour toutes les puces de diode électroluminescente (1),
- le filtre de visibilité commun (4a) est un filtre vert commun, et
- il y a présence d'espaces intermédiaires (6) entre les filtres à UV (3b) et le convertisseur de longueur d'onde (2a) ainsi qu'entre le filtre vert (4a) et le convertisseur de longueur d'onde (2a), lesquels contiennent de l'air ou un matériau de remplissage.

8. Module optoélectronique selon la revendication 1,
qui présente un filtre à UV commun (3a) pour toutes les puces de diode électroluminescente (1) réalisées en tant que DEL-UV, le filtre à UV commun et le filtre de visibilité commun (4a) étant chacun réalisés sous forme de couche plane et agencés en aval des DEL-UV, dans le sens du rayonnement principal, et le filtre à UV commun et le filtre de visibilité commun recouvrant intégralement les DEL-UV.

9. Module optoélectronique selon la revendication 1,
dans lequel le filtre à UV (3) est intégré de manière monolithique dans une puce de diode électroluminescente (1) .

10. Module optoélectronique selon la revendication 1,
dans lequel le filtre à UV (3) est espacé d'une puce de diode électroluminescente (1) dans un sens de rayonnement, de la colle silicone ou une pâte de remplissage se trouvant entre le filtre à UV (3) et la puce de diode électroluminescente (1).

11. Module optoélectronique selon la revendication 1,
dans lequel
- toutes les puces de diode électroluminescente (1) présentent le convertisseur de longueur d'onde (2) en tant que convertisseur de longueur d'onde commun (2a),
- le filtre de visibilité commun (4a) est réalisé en tant que filtre de visibilité pour toutes les puces de diode électroluminescente (1), et
- le filtre à UV (3, 3a, 3b) est un filtre à UV commun (3a) pour toutes les puces de diode électroluminescente (1) réalisées en tant que DEL-UV.

12. Module optoélectronique selon la revendication 1, doté d'au moins deux puces de diode électroluminescente (1), dans lequel
- un filtre à UV (3) qui transmet du rayonnement UV, est associé sans équivoque à chaque puce de diode électroluminescente (1) et est agencé directement en aval de celle-ci, chaque puce de diode électroluminescente (1) étant intégrée de manière monolithique à son filtre à UV (3),
- exactement un convertisseur de longueur d'onde (2) est agencé en aval de l'agencement composé des puces de diode électroluminescente (1) et des filtres à UV (3), et
- exactement un filtre de visibilité (4), à savoir le filtre de visibilité commun (4a), est agencé en aval du convertisseur de longueur d'onde (2).

13. Agencement de projection,
dans lequel un module optoélectronique selon l'une quelconque des revendications 1 à 12 est prévu en tant que source lumineuse.

14. Agencement de projection selon la revendication 13,
dans lequel le module optoélectronique est entouré d'un cadre thermo-conducteur (17).
